# EUROPEAN PATENT APPLICATION

(11) **EP 4 350 674 A1**
(43) Date of publication of application: **10.04.2024**
(21) Application number: 23202192.3
(22) Date of filing: 06.10.2023
(51) Int. Cl.: G09F 9/302, G09F 19/22

(54) **SCREEN OR PANEL SUPPORTING FRAME AND INSTALLATION KIT**

(30) Priority: 07.10.2022 BE 202205807
(71) Applicant: PRG Projects nv, 8400 Oostende (BE)
(72) Inventor: OPSOMER, Frederic, 8400 Oostende (BE); HOSTEN, Mario, 8400 Oostende (BE); FICHEFET, Marc, 8400 Oostende (BE)
(74) Representative: Brantsandpatents bv

(57) **Abstract**

The present invention concerns a frame for supporting screens or panels, typically displays, on a slope, such as stairs, stands, hills, and the like. Furthermore, the invention also concerns a kit for setting up the supporting frame.

## Description

### TECHNICAL DOMAIN

The invention relates to a supporting frame for screens and/or panels, and in particular displays, to be installed under a slope. This amongst others pertains to large-scale display setups, such as in stadiums, buildings, stages, and the like.

### STATE OF THE ART

Existing screen-bearing arrangements are typically not suitable for slopes, and also lack the means to allow construction over a certain range of angles. Fixed installations exist, where these are specifically tailored to allow installation at a known angle. In many cases, however, screen-bearing setups are ambulatory and are transported to (hopefully) be used in different settings, and therefore at different angles of inclination. This causes fewer problems in smaller setups, but larger conditions make 'fixed' structures incompatible with varying angles of inclination.

In addition, the requirements for such structures are also corresponding: on the one hand, they must be particularly modular, and allow different constructions (square, rectangular, variable dimensions); on the other hand, they must also enable simple and quick installation and dismantling; finally, reliability and strength are still crucial. The setups often have to be built in the open air, where the screens can be strongly influenced by gusts of wind, and must therefore be robust enough to withstand them.

Existing support systems for larger screen installations already exist, as described for example in US8803766, but are not capable of being built on slopes, and/or fall short in some of the other areas mentioned above.

The present invention aims to find a solution to at least some of the above problems, and to provide a structurally stable, modular and adaptable arrangement for supporting a multitude of screens at an angle of inclination of the surface.

### SUMMARY OF THE INVENTION

The invention concerns a system, and associated kit for building it, that serves as a supporting frame for screens and/or panels, and in particular displays, such as LED displays, in a setting with level differences on the surface on which the system is built. The frame comprises a plurality of supporting feet, a plurality of support profiles and a plurality of guide profiles, and a plurality of coupling elements.

The precise numbers of each type of sub-component may vary and depend, among other things, on the dimensions of the sub-components themselves, as well as the desired dimension and shape of the frame.

In a first aspect, the invention relates to a screen or panel supporting frame, preferably for supporting displays, further preferably LED displays, comprising:
a. at least 4 supporting feet, each supporting foot comprising an elongated leg, a stabilizer element and a connector, wherein the leg at a first longitudinal end is connected to the top of the stabilizer element, the stabilizer element preferably provided with a flat bottom side opposite to the top side, and wherein the leg at a second longitudinal end is connected to the connector;
b. at least 2 elongated support profiles, whereby at least two of the support profiles are anchored to the connectors of at least two of the support feet at spatially separated positions along the support profiles, preferably where the positions are distanced over a distance of at least 33% of the length of the support profile, wherein the support profiles are positioned parallel to each other and positioned perpendicular to the legs of the support feet;
c. at least two elongated guide profiles suitable for receiving screens and/or panels;
d. at least 4 coupling elements, preferably a coupling element for each supporting foot, comprising a first and a second connector, wherein the first connector of at least two of the coupling elements is anchored on at least two parallel support profiles, and wherein the guide profiles are anchored on the second connector of two coupling elements anchored on different support profiles, and the guide profiles extend parallel to each other and extend perpendicular to the support profiles, wherein the second connector is rotatable relative to the first connector around a rotational axis parallel to the support profile in the first connector, wherein the second connector and first connector are mutually fixable in terms of rotation with respect to the rotation axis.

In a second aspect, the invention concerns a kit for a screen or panel supporting frame, preferably for supporting displays, further preferably LED displays, comprising:
a. at least 4 supporting feet, each supporting foot comprising an elongated leg, a stabilizer element and a connector, wherein the leg at a first longitudinal end is connected to the top of the stabilizer element, the stabilizer element preferably provided with a flat bottom side opposite to the top side, and wherein the leg at a second longitudinal end is connected to the connector;
b. at least 2 elongated support profiles suitable for anchoring in the connectors of the support feet;
c. at least 2 elongated guide profiles suitable for receiving screens and/or panels;
d. at least 4 coupling elements, each comprising a first connector suitable for anchoring the coupling elements on the support profiles, wherein support profiles anchored in the first connector extend relative to the coupling element according to a first passage direction, and comprising a second connector suitable for anchoring the guide profiles in the coupling elements, wherein guide profiles anchored in the second connector extend relative to the coupling element in a second passage direction, wherein the second connector is provided rotatably relative to the first connector around the first passage direction in the coupling element, wherein the second connector and first connector are mutually fixable in terms of rotation around the first transit direction.

### DESCRIPTION OF THE FIGURES

**Figure 1** shows an overview of the basic elements of a possible embodiment of a kit according to the invention.
Figures 2A-T show step by step the method for building a frame according to an embodiment of the invention.

### DETAILED DESCRIPTION

Unless otherwise defined, all terms used in the description of the invention, including technical and scientific terms, have the meanings commonly understood by those skilled in the art of the invention. For a better appreciation of the description of the invention, the following terms are explicitly explained.

"A", "the" and "it" in this document refer to both the singular and the plural unless the context clearly suggests otherwise. For example, "a segment" means one or more than one segment.

When "approximately" or "around" is used in this document for a measurable quantity, a parameter, a period of time or moment, etc., and in particular a dimension or possibly a mass, variations of +/-20% are meant. or less, preferably +/-10% or less, more preferably +/-5% or less, even more preferably +/-1% or less, and even more preferably +/-0.1% or less than and of the quoted value, to the extent that such variations apply to the invention described. However, this must be understood to mean that the value of the quantity for which the term "approximately" or "around" is used is itself specifically disclosed.

The terms "comprise", "comprising", "consist of", "consisting of", "provided with", "have", "having", "include", "including", "contain", "containing" are synonyms and are inclusive or open terms that indicate the presence of what follows, and do not exclude or preclude the presence of other components, characteristics, elements, members, steps, known or described in the prior art.

Quoting numerical intervals through the endpoints comprises all integers, fractions, and/or real numbers between the endpoints, including these endpoints.

In a first aspect, the invention relates to a screen or panel supporting frame, preferably for supporting displays, further preferably LED displays, comprising:
a. at least 4 supporting feet, each supporting foot comprising an elongated leg, a stabilizer element and a connector, wherein the leg at a first longitudinal end is connected to the top of the stabilizer element, the stabilizer element preferably provided with a flat bottom side opposite to the top side, and wherein the leg at a second longitudinal end is connected to the connector;
b. at least 2 elongated support profiles, whereby at least two of the support profiles are anchored to the connectors of at least two of the support feet at spatially separated positions along the support profiles, preferably where the positions are distanced over a distance of at least 33% of the length of the support profile, wherein the support profiles are positioned parallel to each other and positioned perpendicular to the legs of the support feet;
c. at least two elongated guide profiles suitable for receiving screens and/or panels;
d. at least 4 coupling elements, preferably a coupling element for each supporting foot, comprising a first and a second connector, wherein the first connector of at least two of the coupling elements is anchored on at least two parallel support profiles, and wherein the guide profiles are anchored on the second connector of two coupling elements anchored on different support profiles, and the guide profiles extend parallel to each other and extend perpendicular to the support profiles, wherein the second connector is rotatable relative to the first connector around a rotational axis parallel to the support profile in the first connector, wherein the second connector and first connector are mutually fixable in terms of rotation with respect to the rotation axis.

It must be taken into account that the couplings between the above components (supporting foot, support profile, guide profile, coupling element) are releasable, which allows rapid deconstruction and reconstruction.

The support feet can comprise specifically adapted stabilizer elements depending on the surface. In practice, these will have a substantially flat underside, suitable for applications such as stadium setups, stairs or artificial ramps. For applications on a softer and/or more uneven surface (earth, etc.), additional teeth can be provided at the bottom for a more secure anchoring, and additional anchoring elements can be provided to secure the stabilizer element in the surface.

At the top they are equipped with adapted connectors in which the support profiles can be anchored, preferably in such a way that the support profiles can only be fitted in one orientation, whereby the shape prevents rotation of the profiles when present in the connector.

The legs can be provided in different versions. On the one hand, these can be disconnected from the stabilizer element and from the connector, so that legs of a different length can easily be fitted as needed. On the other hand, telescopically extendable legs can be provided, with adjustable length.

The connectors are provided to receive and anchor the support profiles perpendicular to the legs. The connector preferably has a U-shaped groove that extends perpendicular to the leg, in which the profiles can be placed. Anchoring is possible, for example, by providing an anchoring element such as an anchoring pin that passes through a corresponding opening through the two arms of the U-shaped groove and the sides of the profiles, such that the profiles are fixed between the two arms.

The support profiles preferably have a substantially constant cross-section over most of the length, but preferably deviate from this cross-section at the two ends, which are specifically adapted for coupling consecutive support profiles.

The constant cross-section preferably has one axis of symmetry, which runs parallel to the leg of the supporting foot when the support profile is anchored therein.

At one end the support profile preferably has a narrow extension, with an internal cavity at the other end in which the extension of an adjacent support profile can be received and anchored therein, preferably by means of an anchoring pin that runs through the two support profiles. goes perpendicular to its longitudinal axes, preferably perpendicular to the support foot in which the profiles are anchored.

The guide profiles preferably have a substantially constant cross-section over most of the length, but preferably deviate from this cross-section at the two ends, which are specifically adapted for coupling consecutive guide profiles.

The constant cross-section preferably has one axis of symmetry, which runs parallel to the leg of the supporting foot when the guide profile is anchored therein.

At one end the guide profile preferably has a narrow extension or protrusion, with a recess at the other end in which the extension of an adjacent guide profile can be received and anchored therein, preferably by means of at least one, preferably two, anchoring pin that goes through the two guide profiles, perpendicular to their longitudinal axes, preferably perpendicular to the support base in which the profiles are (indirectly) anchored.

The coupling elements are suitable for anchoring on one side to the support profiles and on the opposite side to the guide profiles, such that these two types of profiles are perpendicular to each other. The first and second connectors provided for this anchoring form a groove, with two upright flanks on either side, between which the profiles are received, such that they connect to the flanks and are located on the bottom of the groove. Preferably, both flanks are provided with one or more bores on each flank that are an extension of the bores on the other flank, through which an anchoring pin can be passed. The profiles that are anchored in the connectors also comprise corresponding bores, so that an anchoring pin can be guided through the bores on the flanks of the anchored profiles.

The first connector, which connects to the support profiles, preferably has a recess with a depth that embraces at least 50%, preferably at least 75% of the cross-section of the support profile anchored in it. It is very important to clamp the anchored support profiles as completely as possible with the connector, as this forms the basis on which the above layers (guide profiles and screens) are built.

The second connector, which connects to the guide profiles, preferably has a recess with a depth that embraces at least 25%, preferably at least 33% or even 40% of the cross-section of the guide profile anchored in it.

Providing the first and second connectors rotatably relative to each other makes it possible to build up a supporting frame with the arrangement of the invention in any situation in terms of slope of the surface. By repositioning the connectors relative to each other in angle, it is ensured that the guide profiles are at the correct angle, typically corresponding to the degree of inclination, although it is possible to vary this according to visibility.

Preferably, the first and second connectors are limited in their mutual orientation between two extreme positions, whereby they can be fixed in discrete or continuous intermediate positions. The connectors define a feed-through direction along which the profiles anchored in them extend, and allow mutual rotation of the other connector around an axis parallel to said feed-through direction. This ensures that the support and guide profiles, which are provided perpendicular to each other in the frame, can rotate around each other, and thus accommodate the desired degree of inclination.

In practice, such arrangements will have a substantially higher number of supporting feet, profiles and coupling elements, although a basic arrangement is already possible with the above numbers.

The proposed frame has the advantage that it is very easy to set up and can easily be expanded modularly. Additional support feet, profiles and coupling elements can easily be added and simply tacked onto a basic construction, possibly with additional connecting elements between consecutive profiles.

The coupling elements allow you to work on any slope. In practice, given the large loads that the setup carries and as it is often very sensitive to wind, the maximum angle is limited for safety reasons. The maximum angle is preferably 45°, but preferably at most40° or even 35°.

Of course, this angle can be increased with the help of additional safety measures (additional attachment to structural elements).

Preferably, the second connector is provided with an upright protrusion centrally in the groove or recess flanked by two upright flanks, whereby at least one additional bore is provided in the protrusion, directed from one flank to the other, and the bore is aligned with corresponding bores. in the flanks. These serve to guide an anchoring pin through the bores, which is also guided through corresponding bores in the guide profiles when it is anchored in the coupling element. It should be noted that such an upright protrusion can also be provided in the first connector in a similar manner.

Anchoring pins can be provided with a screw thread, whereby one or more of the bores in which they are received are provided with an associated screw thread pattern, to fix them more firmly in place. Preferably, these screw thread patterns are provided at least, further preferably only, in one or more, preferably all, bores through the flanks of the first and/or second connectors.

In a preferred embodiment, the coupling elements are positioned in line with the legs of the supporting feet, whereby the guide profiles and the support profiles cross at the height of the coupling elements. In this way, the downward load on the coupling elements, acting on them from the guide profiles that support the screens, is transferred as optimally as possible to the support feet.

It is alternatively possible not to position one or more (or even all) coupling elements above supporting feet, which gives the option of providing additional guide profiles or providing them where necessary, possibly deviating from the other guide profiles in terms of shape and/or functionality - for example without the surface-mounted screens and/or panels being anchored therein, but merely resting on them.

In a preferred embodiment, the support feet are connected via one or more elongated support arms to at least one support profile at a point at least 5 cm, preferably at least 10 cm, away from the connection of the connector to the support profile, the support arms extending from the support arms at least 5 cm, preferably at least 10 cm, away from the connector, the support arms preferably forming an angle between 30° and 60° with respect to the legs of the support base. By providing support arms, lateral forces (in the plane defined by the two types of profiles) are absorbed much better. In addition, these also contribute to the redistribution of downward forces on the (support profiles).

In an alternative or further preferred embodiment, such support arms are provided for connection between the guide profiles and the support feet, at a point at least 5 cm, preferably at least 10 cm, away from the connection of the connector with the guide profile, the support arms extending from the support arms at least 5 cm, preferably at least 10 cm, away from the connector, the support arms preferably forming an angle between 30° and 60° with respect to the legs of the support base.

It goes without saying that two support arms can be provided between a support foot and the guide and/or support profile, preferably one arm on either side of the profile relative to the support foot. In certain embodiments, where, for example, additional support is required for the profiles, additional support arms can also be provided on the same side of the profile relative to the support foot, which connect to the profile and/or to the support foot at different positions.

In a further preferred embodiment, the support arms are connected to the support profile via an elongated support arm bracket, which extends parallel to the support profile and is connected thereto at several positions along the length of the support arm bracket. By providing a support arm bracket that connects to the support profile, anchoring to it is better guaranteed, and the forces of the profile on the support arm can be better transmitted, with less risk of damage or mutual movement. The support arm bracket is preferably attached to the support profile at a number of points, with the points spread over the length of the support profile.

The support arm bracket can be provided with a number of discrete anchoring positions to which the support arm can be attached, preferably with anchoring pins that can be passed through bores in both the support arm bracket and the support arm. The support arm bracket can comprise a U-shaped profile into which the support arm can fit with a first end, wherein the bores in the flanks are provided with the U-shape.

In a preferred embodiment, the leg is tiltably attached to the stabilizer element, and the supporting foot comprises a locking element for releasably fixing the angle of the leg relative to the stabilizer element.

Making the angle of the leg relative to the stabilizer element adjustable can serve, among other things, to make the system compatible with unpredictable surfaces and to accommodate any variations in slopes thereof. This is useful both outdoors, where there may be local irregularities that make the slope of the ground unpredictable or general slopes, but also indoors, where conditions may cause an undesirable slope angle at certain positions. This can easily be responded to by providing a tiltable connection between the stabilizer element and the leg. This tilting is preferably possible over one horizontal axis, further preferably on two mutually perpendicular horizontal axes, where horizontal means parallel to the stabilizer element.

In a preferred embodiment, the frame comprises at least 6 support feet, at least 4 support profiles, and at least 6 coupling elements, wherein the support profiles are provided in rows with at least two consecutive support profiles. The consecutive support profiles are connected to each other in line with each other using support brackets that are provided on the underside of each two consecutive support profiles at the connection between the two consecutive support profiles. The support brackets extend for at least 5 cm, preferably at least 10 cm, along and against and parallel to the two consecutive support profiles. Even further preferably, this is at least 30 cm and most preferably at least 50 cm.

Typical versions of the frame provide extensions to the basic version (four legs, two long beam profiles and two cross beam profiles), which can be easily added, using support feet from adjacent 'basic versions' and building further on the support profiles from adjacent basic versions. For example, two additional support feet, two support profiles and two coupling elements will typically be provided per extension to the basic version.

In a further preferred embodiment, the support profiles have a longitudinal recess at a first end and a longitudinal protrusion at a second, opposite end. The protrusion of each support profile is formed for consecutive reception in the recess of a consecutive support profile, further comprising a plurality of anchoring pins, preferably at least two per pair of profiles that can be connected, for releasably anchoring the protrusions in the recesses, preferably provided through the support profiles transverse to the longitudinal direction of the support profiles.

The support profiles are suitable for being anchored into each other, such that part of one support profile is comprised in the other support profile, over a certain minimum length, which ensures that this anchorage can withstand lateral forces and pressure. Preferably, this minimum length is 2.5 cm, more preferably 5.0 cm, even more preferably at least 7.5 cm or even 10.0 cm.

The anchoring pins preferably comprise an elongated cylindrical body, and at one end thereof a branch, which is at an angle of at least 30°, preferably at least 80° and most preferably about 90°, with respect to the elongated cylindrical body. Such pins allow you to easily insert and remove them.

In a preferred embodiment, the frame comprises at least 6 supporting feet, at least 4 guide profiles, and at least 6 coupling elements, wherein the guide profiles are provided in rows with at least two consecutive guide profiles. The consecutive guide profiles are connected to each other in line with each other using support brackets that are provided on the underside of each two consecutive guide profiles at the connection between the two consecutive guide profiles. The support brackets extend for at least 20 cm, preferably at least 40 cm, along and against and parallel to the two consecutive guide profiles. Even further preferably, this is at least 60 cm and most preferably at least 80 cm.

Just as with the extensions with multiple support profiles, a 'length' extension can also be provided by connecting multiple 'basic versions' via the guide profiles.

In a further preferred embodiment, at least one of the support brackets extends to the nearest connector and is anchored to said nearest connector, preferably wherein said at least one of the support brackets is located at a free end of the guide profiles and connects consecutive guide profiles.

This additional anchoring to the connector provides additional stability and allows some of the forces exerted on the profiles, and therefore on the support bracket, to be supported by the support feet, to which the connector is indirectly connected.

However, in most cases, different basic versions will be linked in the direction of the support profiles and in the direction of the guide profiles, creating a matrix structure, providing lateral support to the profiles in each direction. The number of elements required depends on the matrix structure, but can be generally determined as follows: in the case of an M on N structure, with M the number of screens in the length or rather, in the 'height' (the slope upwards), and N the number of screens in width, (M+1) x (N+1) support feet and coupling elements must be provided, (M+1) x N support profiles and M x (N+1) guide profiles.

In certain variations, additional support feet and/or coupling elements can be provided, where additional support and/or connection is required.

In a further preferred embodiment, the guide profiles have a longitudinal recess at a first end and a longitudinal protrusion at a second, opposite end. The protrusion of each guide profile is shaped for consecutive reception in the recess of a consecutive guide profile. The frame further comprises a plurality of anchoring pins for releasably anchoring the protrusions in the recesses, preferably provided through the guide profiles transverse to the longitudinal direction of the guide profiles.

The anchoring pins preferably comprise an elongated cylindrical body, and at one end thereof a branch, which is at an angle of at least 30°, preferably at least 80° and most preferably about 90°, with respect to the elongated cylindrical body. Such pins allow you to easily insert and remove them.

In a preferred embodiment, the frame comprises one or more support ribs that connect two parallel guide profiles, whereby the support ribs are provided parallel to the support profiles between the guide profiles and are provided at a distance of at least 5 cm, preferably at least 10% of the shortest distance. between two parallel support profiles, relative to the nearest support profile.

Furthermore, the support ribs are preferably connected to the guide profiles via the support brackets.

The support ribs can provide additional support to the guide profiles that often have to withstand a heavier load. Below this they are less resistant to lateral forces, and there is a risk that they will bend under load, be it static load (such as the screens) or occasional load (gusts). These can be connected much more easily to the guide profiles, for example through anchoring pins through the guide profiles that anchor themselves in the support ribs at the ends, and do not have to be supported vertically.

In a preferred embodiment, the first and second connectors comprise U-shaped grooves in the coupling element, wherein the grooves are perpendicular to each other. The support profiles have a cross-section that is suitable for substantially fitting into the groove of the first connector, and the guide profiles have a cross-section suitable for substantially fitting in the groove of the second connector, preferably where the cross-section has a maximum of two axes of symmetry. The symmetry of the profiles makes installation easier and ensures equal load distribution.

The coupling elements are preferably constructed from two U-shaped profiles, approximately equal to each other, which are connected to each other on either side and on the upright legs with one or more beams for structural strength.

The depth of the U-shaped recess in the U-shaped profiles defines the first connector, for the support profiles, and preferably has a depth of at least 5.0 cm.

Both U-shaped profiles have a flank added to the base and in line with the U-shaped profiles, which extends beyond the base of the U-shaped profiles. These flanks extend at least 2.5 cm, preferably at least 3.5 cm, beyond the base.

The second connector extends between these two flanks, which is defined by the two upright flanks and a flat conductor between them, preferably with upright protrusion. This flat guide is preferably reinforced by two support plates that are at an angle between 70° and 110°, preferably approximately 90°, with respect to the flat guide, with a first support plate located between the first legs of the two U-shaped profiles. and a second support plate is located between the second legs of the two U-shaped profiles. The flat guide is approximately at the base of the U-shaped profiles.

The total height of the coupling element is preferably at least 10.0 cm, preferably at least 15.0 cm, whereby the height is calculated from the distal ends of the flanks to the end of the legs of the U-shaped profiles. The coupling elements have a width of at least 10.0 cm, preferably at least 15.0 cm and most preferably approximately 20.0 cm, wherein the width is the dimension along the groove of the second connector. The coupling elements have a length of at least 10.0 cm, preferably at least 12.5 cm and most preferably approximately 15.0 cm, calculated along the groove of the first connector.

If there is an upright protrusion in the grooves, it is preferably at least 2.5 cm, further preferably at least 3.5 cm, high compared to the plane on which it stands.

In a preferred embodiment, the second connector is rotatable relative to the first connector about the rotational axis between two extremal rotational positions, with the two extremal ones rotational positions make an angle of at least 15°, preferably at least 20°, more preferably at least 25°, and at most 60°, and preferably at most 50°, more preferably at most 45°. In certain embodiments, discrete positions are provided at which the angle can be anchored, for example every 5°, preferably every 2.5°, further preferably every 1° or even lower. Alternatively, continuous positioning and anchoring may be possible in order to respond even more specifically to specific circumstances and to enable optimal positioning.

In principle, higher angles can be allowed, but under such slopes, other solutions are more advisable.

The second connector is movably arranged relative to the first connector, but is guided by one or more rotation pins that extend from the second connector through one or both U-shaped profiles in a guide groove that connects the two most extremal defines rotational positions, thus allowing rotation.

Alternatively, the two U-shaped profiles can be firmly connected by the flat guide, with support plates that directly connect the two legs of the profiles. One or more U-shaped elements are then provided in the U-shaped opening of the profiles, which are connected to each other and which are rotatably attached to the profiles.

These U-shaped connector elements are arranged movably relative to the second connector, and in particular the U-shaped profiles, wherein these U-shaped elements are guided by one or more rotation pins that extend from the U-shaped elements through one or both U-shaped profiles in a guide groove connecting the two most extremal ones defines rotational positions, thus allowing rotation.

In a preferred embodiment, the frame comprises a plurality of screens, preferably displays, and most preferably LED displays, said displays and guide profiles suitable for holding the displays in the guide profiles, wherein the displays are slidable along the longitudinal axis of the guide profiles. The current invention allows a particularly simple construction of the frame and a quick and reliable installation of the panels, which can be slid into the guide profiles at an angle at the bottom or top of the arrangement.

In a preferred embodiment, the support profiles have a length between 2.0 m and 10.0 m, preferably between 4.0 m and 8.0 m, further preferably between 5.0 m and 7.0 m, even more preferably between 5.5 m and 6.5 m, and most preferably preferably about 6 m.

Preferably, the support profiles have a width between 3.0 and 11.0 cm, further preferably between 5.0 cm and 9.0 cm and even further preferably between 6.0 cm and 8.0 cm. The width is the dimension of the support profiles perpendicular to the length and in the plane defined by the profiles when the frame is constructed.

The support profiles preferably have a height between 6.0 and 15.0 cm, more preferably between 8.0 cm and 13.0 cm and even more preferably between 10.0 cm and 11.0 cm. The height is the dimension of the support profiles perpendicular to the plane defined by the profiles when the frame is constructed.

In a preferred embodiment, the guide profiles have a length between 3.0 m and 8.0 m, preferably between 4.0 m and 7.0 m, further preferably between 5.0 m and 6.0 m, most preferably approximately 5.5 m.

The guide profiles preferably have a width between 6.0 and 14.0 cm, more preferably between 8.0 cm and 12.0 cm and even more preferably between 9.0 cm and 11.0 cm. The width is the dimension of the guide profiles perpendicular to the length and in the plane defined by the profiles when the frame is constructed.

The guide profiles preferably have a height between 7.0 and 15.0 cm, more preferably between 9.0 cm and 13.0 cm and even more preferably between 10.0 cm and 12.0 cm. The height is the dimension of the guide profiles perpendicular to the plane defined by the profiles when the frame is constructed.

In a preferred embodiment, the supporting foot comprises an interchangeable leg part, which can be replaced. In this way the length of the support foot can be easily adjusted.

Possible materials for the leg part comprise bamboo or other types of wood, given their lightness and strength, as well as ecological benefits.

In general, the support foot preferably has a minimum length between 50 cm and 300 cm, preferably between 75 cm and 200 cm, further preferably between 125 and 175 cm, and most preferably approximately 150 cm.

The stabilizer element preferably has a square shape, with a minimum side of 15.0 cm to guarantee sufficient strength, and preferably at least 20.0 cm, or even 22.5 cm or 25.0 cm. The element has a thickness between 2.0 and 5.0 cm, preferably between 3.0 and 4.0 cm. The stabilizer element is preferably sufficiently heavy, solid, and provided with one or more lifting elements, such as ears.

In a second aspect, the invention concerns a kit for a screen or panel supporting frame, preferably for supporting displays, further preferably LED displays, comprising:
a. at least 4 supporting feet, each supporting foot comprising an elongated leg, a stabilizer element and a connector, wherein the leg at a first longitudinal end is connected to the top of the stabilizer element, the stabilizer element preferably provided with a flat bottom side opposite to the top side, and wherein the leg at a second longitudinal end is connected to the connector;
b. at least 2 elongated support profiles suitable for anchoring in the connectors of the support feet;
c. at least 2 elongated guide profiles suitable for receiving screens and/or panels;
d. at least 4 coupling elements, each comprising a first connector suitable for anchoring the coupling elements on the support profiles, wherein support profiles anchored in the first connector extend according to a first passage direction relative to the coupling element, and comprising a second connector suitable for anchoring the guide profiles in the coupling elements, wherein guide profiles anchored in the second connector extend in a second passage direction relative to the coupling element, wherein the second connector is provided rotatably around the first passage direction in the coupling element relative to the first connector, wherein the second connector and first connector are mutually fixable in terms of rotation around the first transit direction.

In further preferred embodiments, the kit follows one or more of the embodiments of the frame according to the first aspect of the invention.

In the following, the invention is described by way of non-limiting examples that illustrate the invention and are not intended or should be construed to limit the scope of the invention.

### FIGURE DESCRIPTION

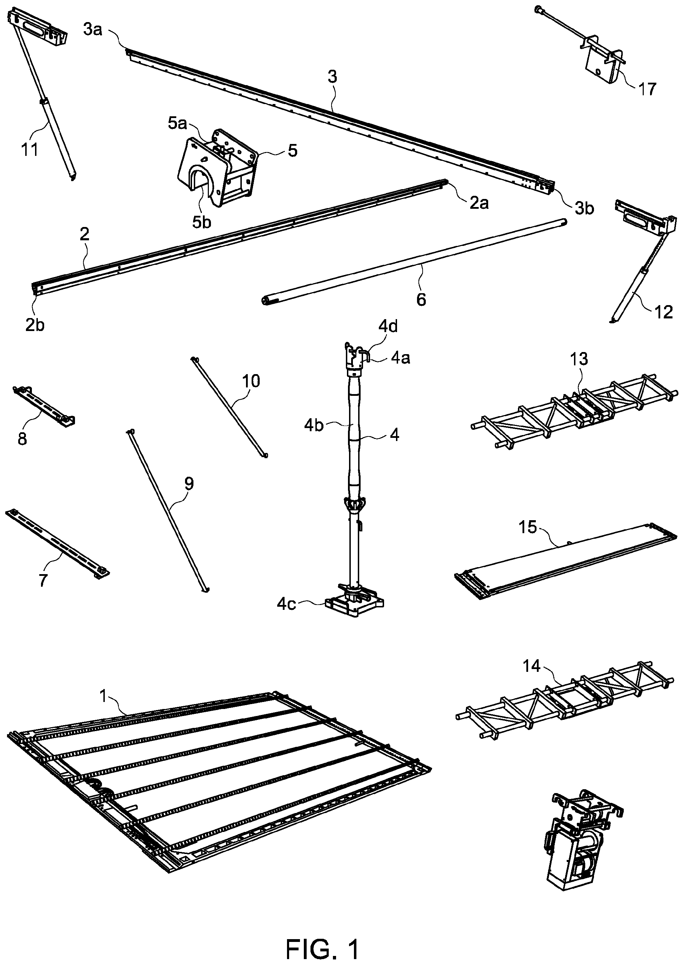

Figure 1 gives an overview of the parts for an embodiment of the frame or kit according to the invention. A number of these elements are optional, such as for additional support or for loading and unloading the screens.

In particular, Figure 1 shows the basic components, such as a screen or LED panel (1), a guide profile (3), a support profile (2), a support foot (4) with connector (4a), leg (4b) and stabilizer element (4c)), a coupling element (5), with first and second connectors (5a, 5b).

In addition, the following elements are provided (singular or plural): support arms (9, 10), support brackets (7, 8), a support rib (6), upper support brackets (11), lower support brackets (12), top loading frame (13), loading bracket (15), bottom loading frame (14), winch (16), screen stop (17).

The support arms and support brackets can be divided according to use, namely for support/connection of the support profiles or of the guide profiles with the support feet. For example, support brackets (8) are provided that are attached separately from the support feet to one or two profiles (and in the second case, connect them), or support brackets (7) are provided that additionally connect the profiles to the support feet for extra strength. In addition, specific support arms (9) are provided for connection to the guide profiles, via the support brackets (7, 8), or support arms (10) for connection to the support profiles.

Support brackets (11, 12) can be provided at the ends of the guide profiles, which provide additional strength to the construction, and on which a loading structure can be placed for loading the screens/panels. This loading structure comprises - depending on whether loading is from below or from above - a top loading frame (13) or bottom loading frame ( 14) and a loading bracket (15), and a winch for lowering or raising the screens/panels.

When loading from above, a top loading frame (13) is provided at the bottom, on the lower support brackets (12) and a bottom loading frame (14) is provided at the top on the upper support brackets (11). If loading is done from below, the bottom loading frame (14) is provided at the bottom on the lower support brackets (12) and a top loading frame (13) is provided at the top on the upper support brackets (11).

The winch (16) is provided on the side where loading takes place. The loading bracket (15) is moved along the guide profiles by means of the winch (16), which is attached to the top or bottom loading frame.

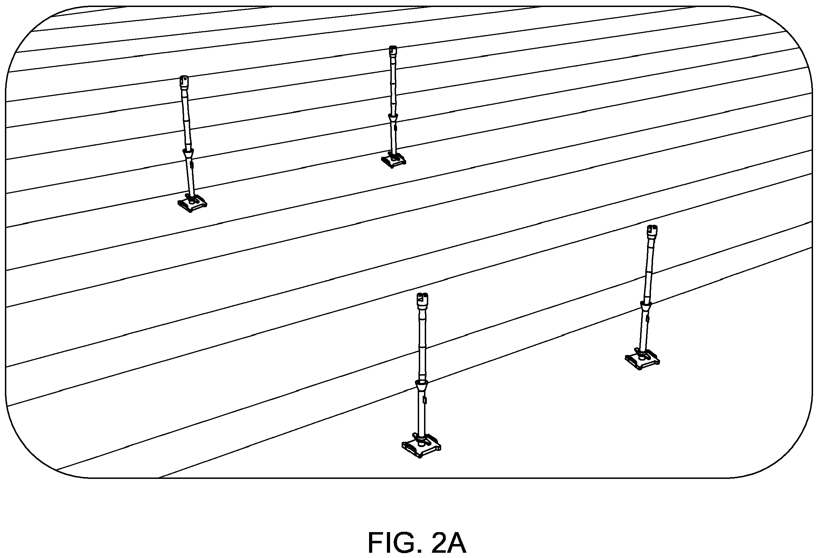

Figures 2A-2T show the procedure for setting up the structure according to an embodiment of the invention.

In Fig. 2A, the support feet (4) are placed at the desired positions, taking into account the length of the support and guide profiles. In addition, the feet can also be adjusted in length to ensure that the assembled setup can support the panels/screens in the desired way. Typically, this is such that they all lie in the same plane, but variations can also be provided if desired.

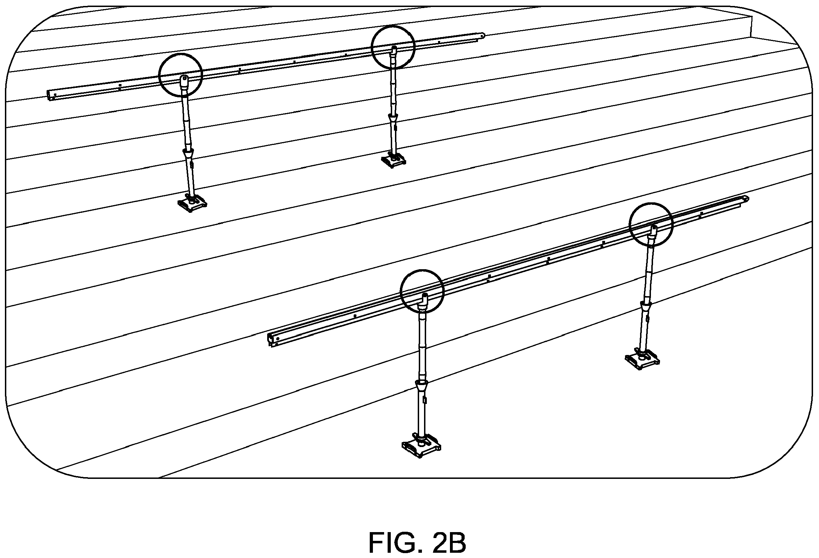

The support profiles (2) are placed on the support feet (4), on the connectors (4a), and locked onto them with a pin (4d) or similar element, as shown in Fig. 2B.

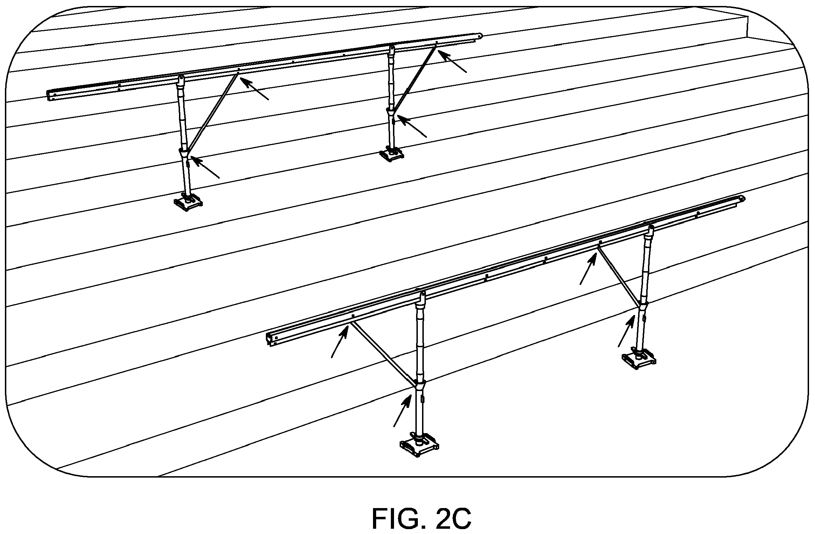

In Fig. 2C, support arms (10) are added that additionally support the support profiles (2) and connect them to the support feet (4).

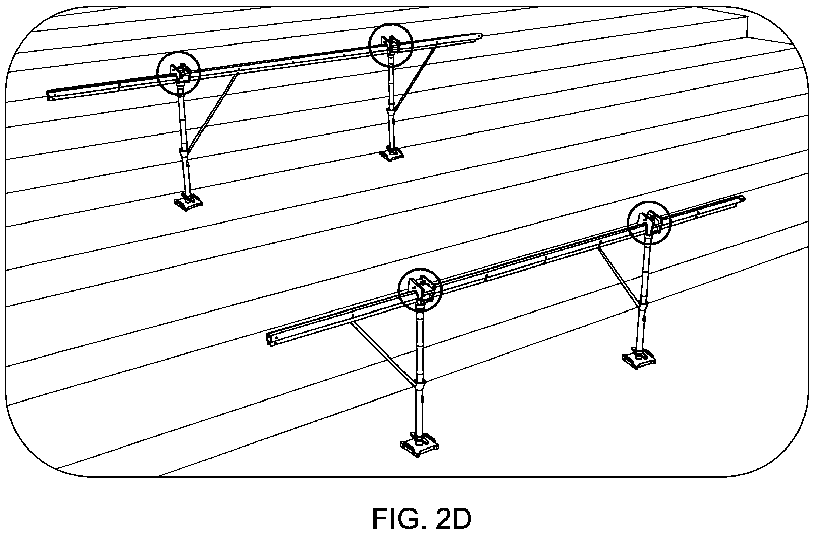

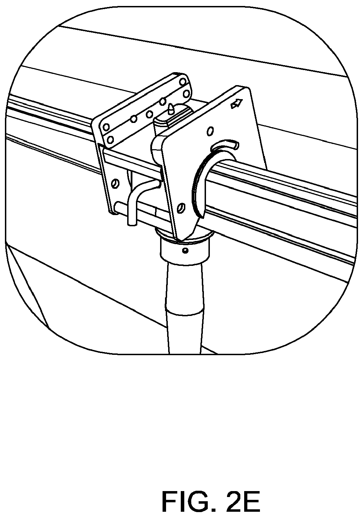

In Fig. 2D, the coupling elements (5) are provided on the support profiles (2) with the first connector (5a), at the level of the support feet (4). Fig. 2E indicates how the coupling elements (5) are locked on the support profiles (2) with a pin.

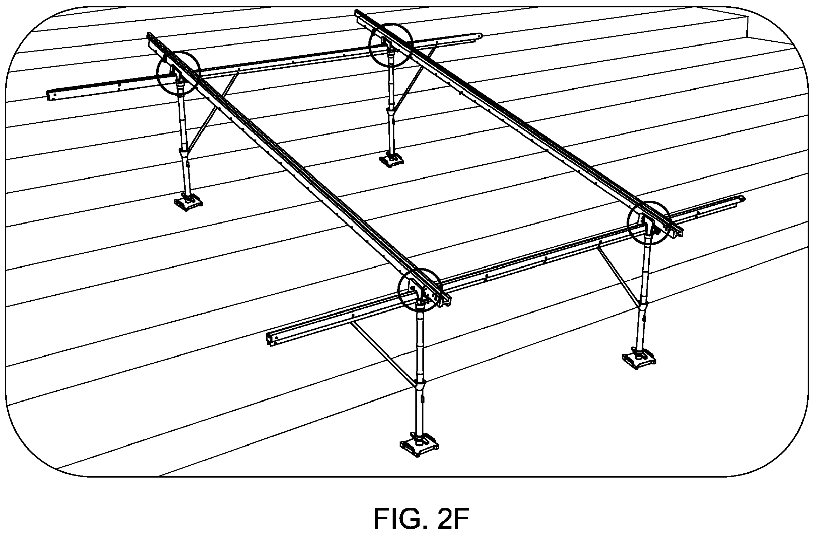

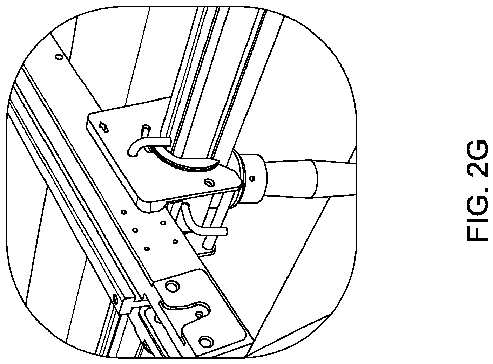

The guide profiles (3) are secured in the second connector (5b) of the coupling elements (5) in Fig. 2F, with more detail about the anchorage via a pin in Fig. 2G. The pin runs, just as with the anchorage with the support profiles, through the coupling element and the profile.

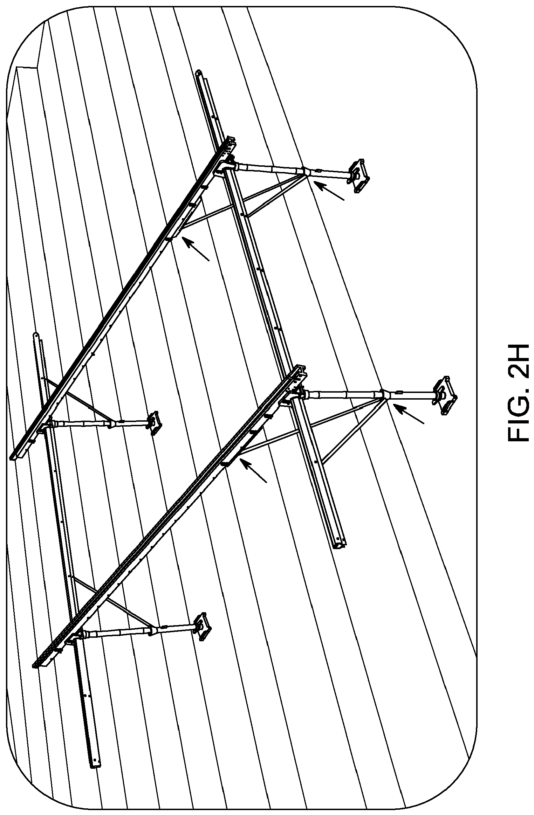

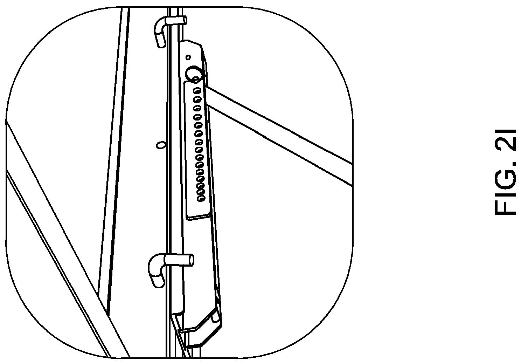

Support arms (9) are added in Fig. 2H and 2I, where these are connected to the support feet and via a support bracket (8) to the guide profiles (3). Typically the support bracket (8) is re-anchored to the profiles via pins.

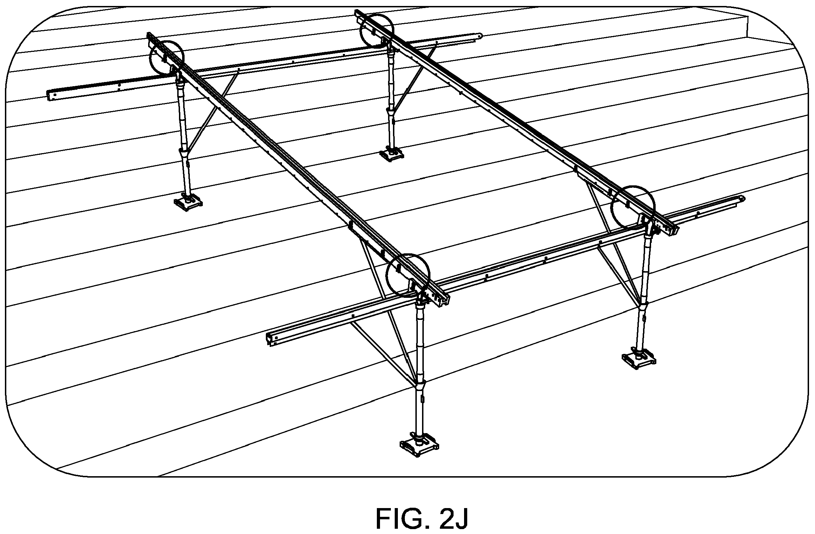

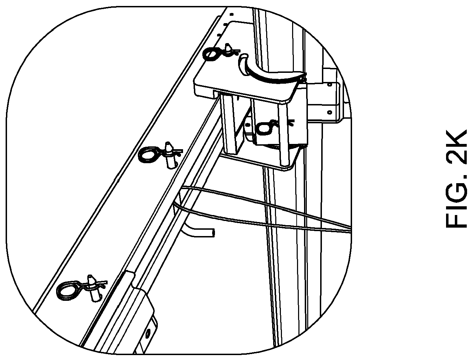

In Fig. 2J and 2K show an additional anchoring measure, namely anchoring the structure to the ground (for example to a seat or other stationary element) via a locking pin through the guide profile (3) by means of a strap.

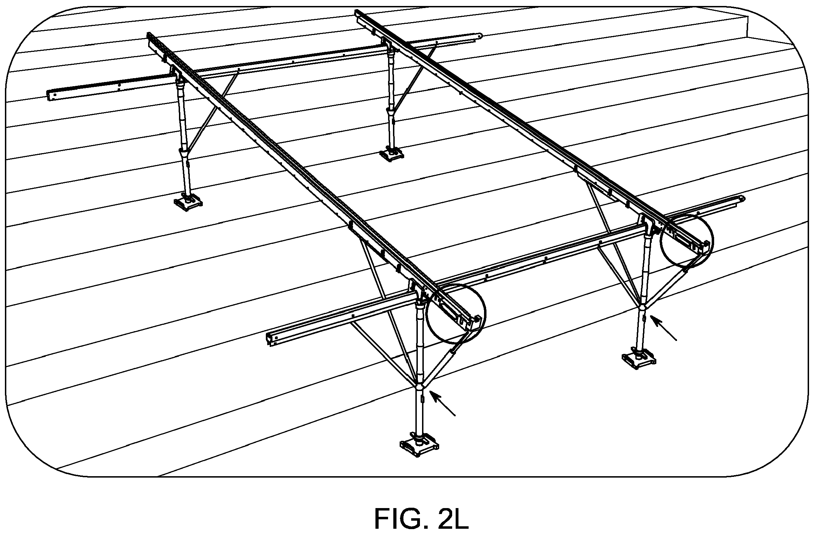

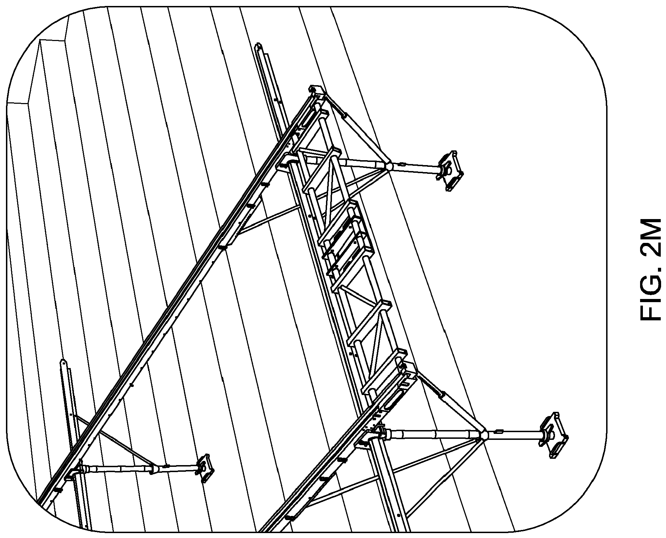

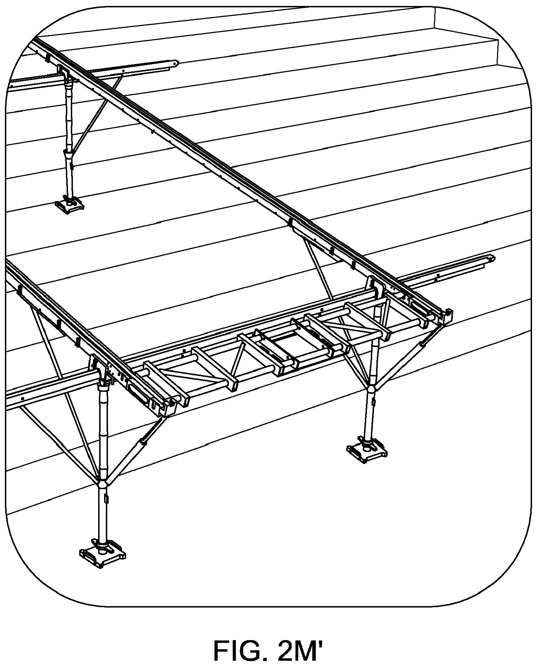

In Fig. 2L, lower support brackets (12) are provided at the bottom of the entire setup, supported by a support arm attached to the support base (4). In Fig. 2M, a top loading frame (13) is provided at the bottom, for top to bottom loading of the screens/panels.

Fig. 2M' shows the alternative, in which loading is done bottom to top, and a bottom loading frame (14) is provided at the bottom.

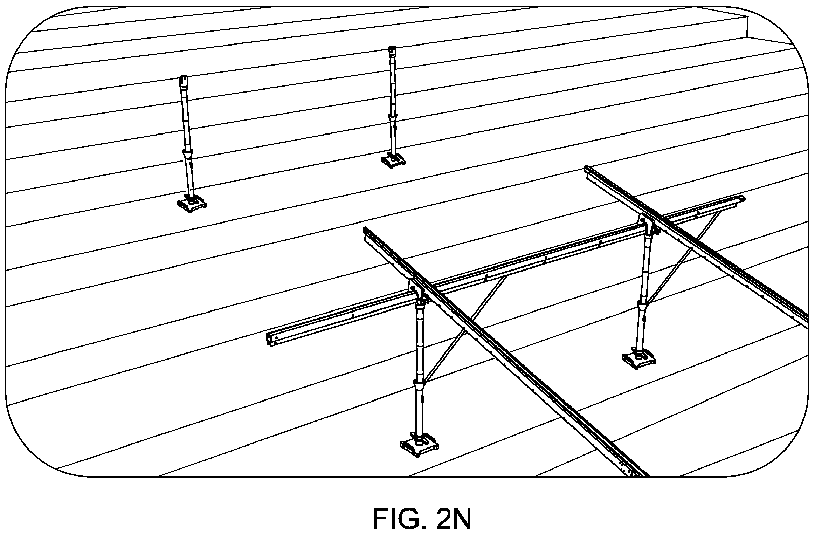

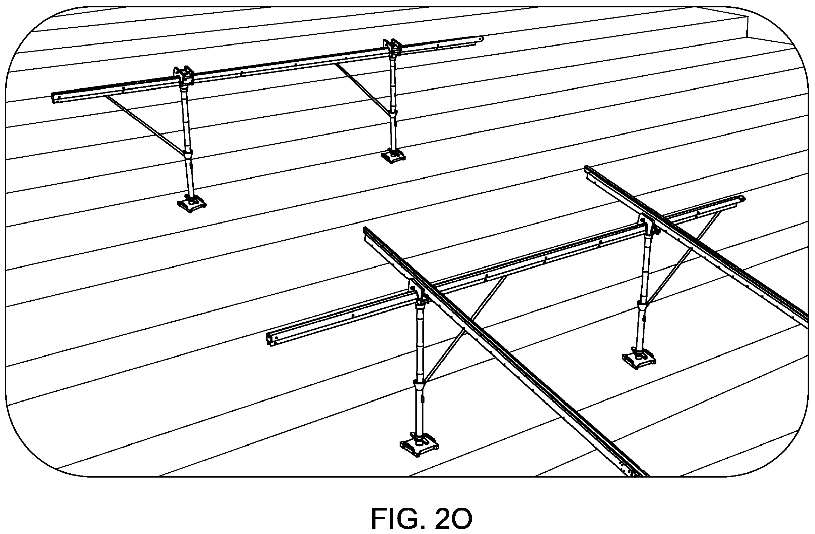

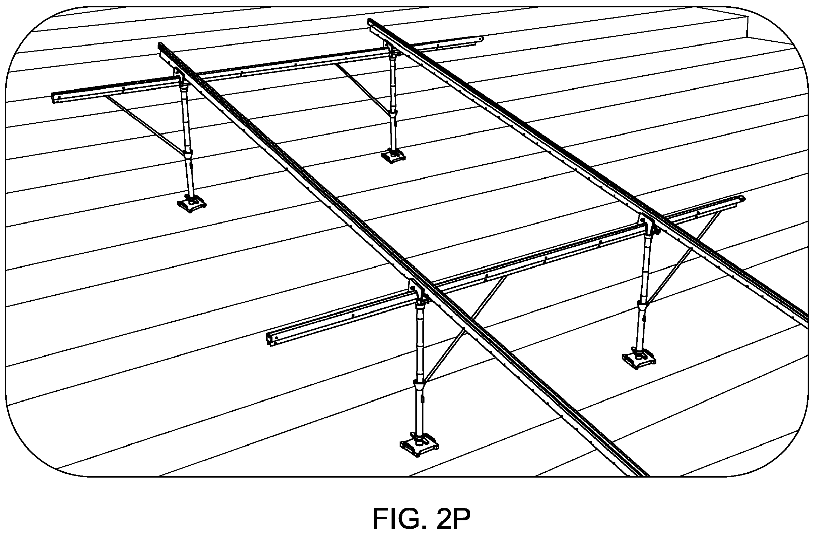

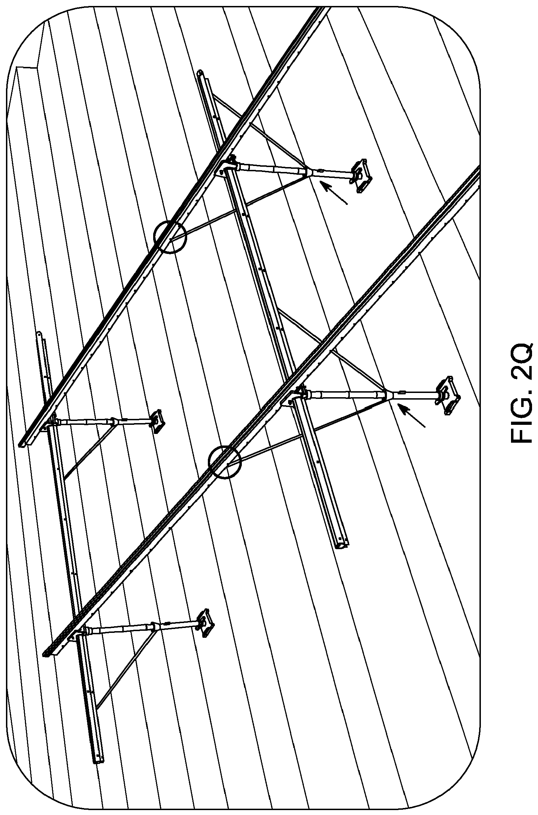

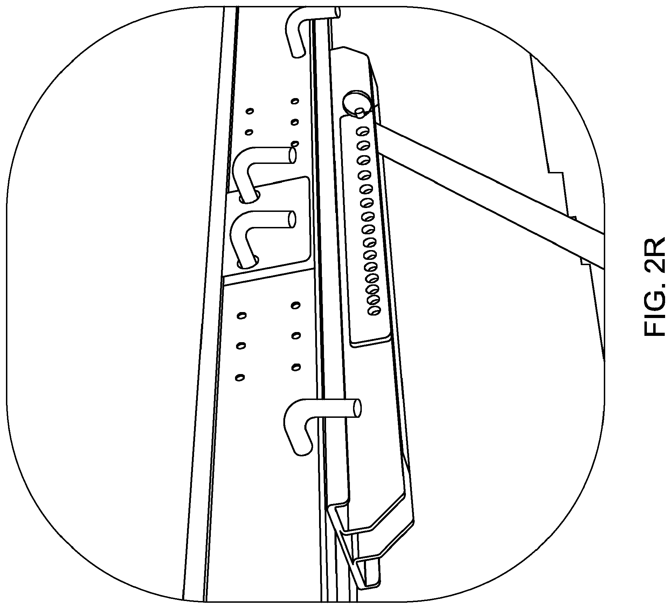

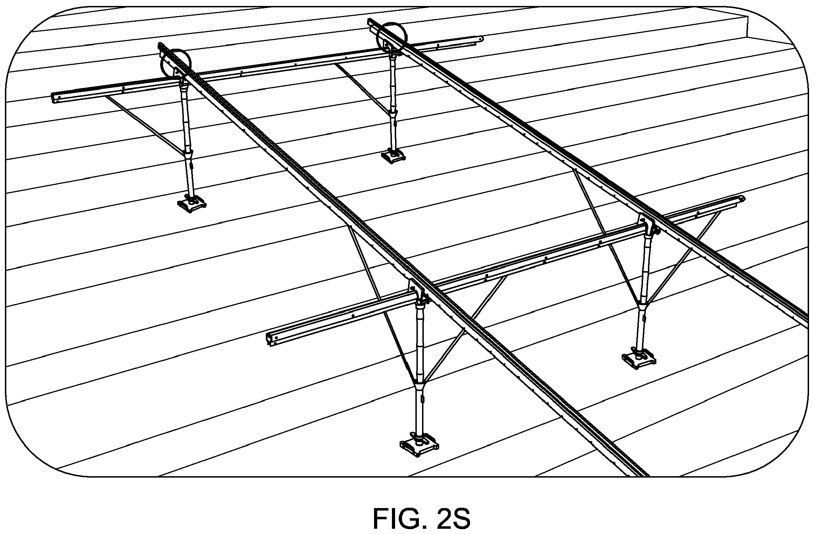

Fig. 2N shows the next step, in which two new support feet (4) are placed at a higher position, which are then shown in Fig. 2O can be provided with a support profile (2), coupling elements (5) and support arms (10) as with the original four feet. In Fig. 2P the guide profiles (3) are added, again in the coupling elements (5). The newly added guide profiles (3) are connected to previously existing guide profiles (3) in their extension using a support bracket (8), and provided with a support arm (9) as before, which can be seen in Fig. 2Q and Figs. 2R. Again, an additional anchorage can be provided as shown in Fig. 2S, via an anchoring pin through the guide profile, to which a strap is attached that is anchored to a stationary element in the environment.

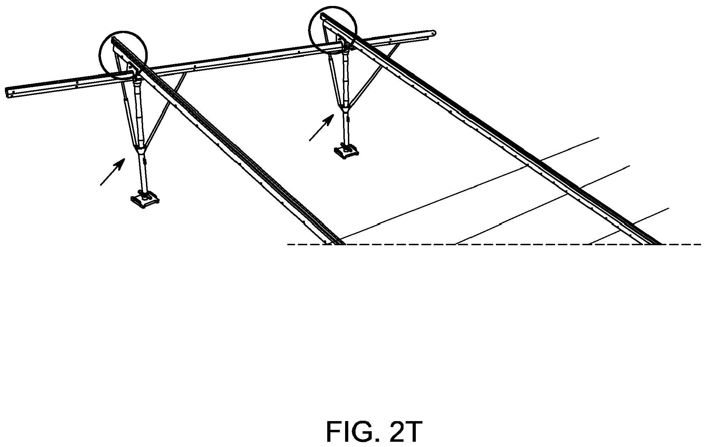

These steps can be repeated until a desired height is reached, with the top, as shown in Fig. 2T, upper support brackets are provided.

Finally, a width expansion can be provided in a similar way by installing support feet, new support profiles, coupling elements, guide profiles, and the like, all similar to the above steps.

It is understood that the present invention is not limited to the embodiments described above and that some modifications or changes may be added to the described examples without revising the appended claims. For example, the present invention has been described with reference to support for displays, but it should be understood that the invention can be applied to e.g. stages.

## Claims

1. Screen or panel supporting frame, preferably for supporting displays, more preferably LED displays, comprising:
a. at least 4 supporting feet, each supporting foot comprising an elongated leg, a stabilizer element and a connector, wherein the leg is at a first longitudinal end connected to the top of the stabilizer element, the stabilizer element preferably being provided with a flat underside oppositely positioned to the top, and wherein the leg is at a second longitudinal end connected to the connector;
b. at least 2 elongated support profiles, whereby at least two of the support profiles are anchored to the connectors of at least two of the support feet at spatially separated positions along the support profiles, preferably where the positions are distanced over a distance of at least 33% of the length of the support profile, wherein the support profiles are positioned parallel to each other and positioned perpendicular to the legs of the support feet;
c. at least two elongated guide profiles suitable for receiving screens and/or panels;
d. at least 4 coupling elements, preferably a coupling element for each supporting foot, comprising a first and a second connector, wherein the first connector of at least two of the coupling elements is anchored on at least two parallel support profiles, and wherein the guide profiles are anchored on the second connector of two coupling elements anchored on different support profiles, and the guide profiles extend parallel to each other and extend perpendicular to the support profiles, wherein the second connector is rotatable relative to the first connector around a rotational axis parallel to the support profile in the first connector, wherein the second connector and first connector are mutually fixable in terms of rotation with respect to the rotation axis.

2. Screen or panel supporting frame according to the preceding claim 1, wherein the coupling elements are positioned in line with the legs of the supporting feet, wherein the guide profiles and the support profiles cross at the level of the coupling elements.

3. Screen or panel supporting frame according to one of the preceding claims 1 or 2, wherein the support feet are connected via one or more elongated support arms to at least one support profile at a point at least 5 cm, preferably at least 10 cm, away from the connection of the connector with the support profile, the support arms extending from the support arms at least 5 cm, preferably at least 10 cm, away from the connector, the support arms preferably forming an angle between 30° and 60° with respect to the legs of the support base.

4. Screen or panel supporting frame according to the preceding claim 3, wherein the support arms are connected to the support profile via an elongated support arm bracket, which extends parallel to the support profile and is connected thereto at multiple positions along the length of the support arm bracket.

5. Screen or panel supporting frame according to any of the preceding claims 1 to 5, wherein the leg is tiltably attached to the stabilizer element, and the supporting foot comprises a locking element for releasably fixing the angle of the leg relative to the stabilizer element.

6. Screen or panel supporting frame according to any of the preceding claims 1 to 5, comprising at least 6 support feet, at least 4 support profiles, and at least 6 coupling elements, wherein the support profiles are provided in rows with at least two consecutive support profiles, and the consecutive support profiles are connected in line with each other using support brackets that are provided at the bottom of each two consecutive support profiles at the level of the connection between the two consecutive support profiles, and where the support brackets extend over at least 5 cm, preferably at least 10 cm along and against and parallel to the two consecutive support profiles.

7. Screen or panel supporting frame according to the preceding claim 6, wherein the support profiles have a longitudinal recess at a first end, and have a longitudinal protrusion at a second, opposite end, the protrusion of each support profile being shaped to be fittingly received in the recess of a consecutive support profile, further comprising a plurality of anchoring pins for releasably anchoring the protrusions in the recesses, preferably provided through the support profiles transverse to the longitudinal direction of the support profiles.

8. Screen or panel supporting frame according to any of the preceding claims 1 to 7, comprising at least 6 support feet, at least 4 guide profiles, and at least 6 coupling elements, wherein the guide profiles are provided in rows with at least two consecutive guide profiles, and the consecutive guide profiles are connected in line with each other using support brackets that are provided at the bottom of each two consecutive guide profiles at the level of the connection between the two consecutive guide profiles, and where the support brackets extend over at least 20 cm, preferably at least 40 cm along and against and parallel to the two consecutive guide profiles.

9. Screen or panel supporting frame according to the preceding claim 8, wherein at least one of the support brackets extends to the nearest connector, and is anchored to said nearest connector, preferably wherein said at least one of the support brackets is located at a free end of the guide profiles and connect consecutive guide profiles.

10. Screen or panel supporting frame according to the preceding claim 8 or 9, wherein the guide profiles have a longitudinal recess at a first end, and have a longitudinal protrusion at a second, opposite end, the protrusion of each guide profile being shaped to be fittingly received in the recess of a consecutive guide profile, further comprising a plurality of anchoring pins for releasably anchoring the protrusions in the recesses, preferably provided through the guide profiles transverse to the longitudinal direction of the guide profiles.

11. Screen or panel supporting frame according to any of the preceding claims 1 to 10, comprising one or more support ribs which connect two parallel guide profiles, wherein the support ribs are provided parallel to the support profiles between the guide profiles and are provided at a distance of at least 5 cm, preferably at least 10% of the shortest distance between two parallel support profiles, relative to the nearest support profile, and preferably according to the preceding claim 9, wherein the support ribs are connected to the guide profiles via the support brackets.

12. Screen or panel supporting frame according to any of the preceding claims 1 to 11, wherein the first and second connectors comprise U-shaped grooves in the coupling element, wherein the grooves are perpendicular to each other, wherein the support profiles have a suitable cross-section to fit substantially snugly into the groove of the first connector, and wherein the guide profiles have a cross-section suitable to fit substantially snugly into the groove of the second connector, preferably wherein the cross-section has a maximum of two axes of symmetry.

13. A screen or panel supporting frame according to any one of the preceding claims 1 to 12, wherein the second connector is rotatable relative to the first connector about the rotational axis between two extremal rotational positions, the two extremal rotational positions having an angle of at least 15°, preferably at least 20°, further preferably at least 25°, and at most 60°, and preferably at most 50°, further preferably at most 45°.

14. Screen or panel supporting frame according to any of the preceding claims 1 to 13, comprising a plurality of screens, preferably screens, and most preferably LED screens, said screens and guide profiles suitable for holding the screens in the guide profiles, where the screens can be slid along the longitudinal axis of the guide profiles.

15. Kit for a screen or panel supporting frame, preferably for supporting displays, further preferably LED displays, comprising:
a. at least 4 supporting feet, each supporting foot comprising an elongated leg, a stabilizer element and a connector, wherein the leg is at a first longitudinal end connected to the top of the stabilizer element, the stabilizer element preferably provided with a flat underside opposite to the top, and wherein the leg is at a second longitudinal end connected to the connector;
b. at least 2 elongated support profiles suitable for anchoring in the connectors of the support feet;
c. at least 2 elongated guide profiles suitable for receiving screens and/or panels;
d. at least 4 coupling elements, each comprising a first connector suitable for anchoring the coupling elements on the support profiles, wherein support profiles anchored in the first connector extend relative to the coupling element according to a first passage direction, and comprising a second connector suitable for anchoring the guide profiles in the coupling elements, wherein guide profiles anchored in the second connector extend relative to the coupling element in a second passage direction, wherein the second connector is provided rotatably relative to the first connector around the first passage direction in the coupling element, wherein the second connector and first connector are mutually fixable in terms of rotation with respect to the first transit direction.
